# EUROPEAN PATENT APPLICATION

(11) **EP 2 738 946 A1**
(43) Date of publication of application: **04.06.2014**
(21) Application number: 11869961.0
(22) Date of filing: 26.07.2011
(51) Int. Cl.: H04B 1/40

(54) **WIRELESS APPARATUS**

(71) Applicant: Fujitsu Limited, Kawasaki-shi, Kanagawa 211-8588 (JP)
(72) Inventor: OHTSUKI, Kazuya, Kawasaki-shi Kanagawa 211-8588 (JP); NIBE, Keiji, Kawasaki-shi Kanagawa 211-8588 (JP)
(74) Representative: Stebbing, Timothy Charles
(86) International application number: PCT/JP2011/066986
(87) International publication number: WO 2013/014752

(57) **Abstract**

The problem is to suppress the occurrence of a communication error caused by a fluctuation in power supply voltage. A cellular phone 100 includes a wireless unit 202 that performs signal processing on a radio signal and a baseband processing unit 302 that is connected to the wireless unit 202 through a digital communication channel and transmits/receives a digital signal with the wireless unit 202 through the digital communication channel. The cellular phone 100 further includes a middleware 406 that detects whether an event causing a fluctuation in power supply voltage supplied to the wireless unit 202 or the baseband processing unit 302 is initiated. The cellular phone 100 still further includes an amplitude-level control unit 350 that increases, when the middleware 406 has detected that the event is initiated, amplitude of a digital signal transmitted/received through the digital communication channel before the event is initiated.

## Description

The present invention relates to a wireless device.

### [Background Art]

Conventionally, a wireless device, such as a cellular phone, is configured to include an RF (Radio Frequency) unit (a wireless unit) and a baseband processing unit, and an interface between the RF unit and the baseband processing unit includes an analog signal line and a digital or analog control line.

However, in recent years, with the development of an RF-IC (Integrated Circuit) CMOS (Complementary Mental-Oxide Semiconductor), it has become possible to embed an ADC (Analog Digital Converter) or a DAC (Digital Analog Converter) into an RF-IC. In response to this, there has been established a standard called "DigRF" in which an RF-IC and a digital IC for baseband processing are connected by a digital communication channel.

In a version called DigRF v3 of the DigRF standard, a differential signal is transmitted/received between an RF-IC and a digital IC for baseband processing through a digital communication channel. It is known that in a conventional technology, to reduce power consumption of a wireless device, when the wireless device is in sleep, a differential signal transmitted/received through the digital communication channel is controlled to a smaller amplitude level than normal communication.

### [Citation List]

### [Patent Citation]

Patent Document 1: Japanese Laid-open Patent Publication No. 2010-56977

### [Summary of Invention]

### [Technical Problem]

However, the conventional technology does not consider suppressing the occurrence of a communication error caused by a fluctuation in power supply voltage.

Namely, in DigRF v3, the amplitude level of a differential signal is adjusted so that an eye pattern formed by a waveform of the differential signal satisfies a range specified by the standard. Meanwhile, there is expected to suppress power consumption of the wireless device, so the amplitude level of a differential signal is adjusted to be as small as possible.

Therefore, when there is a fluctuation in power supply voltage supplied to the RF-IC or the digital IC for baseband processing due to activation of an application such as a TV phone of the wireless device, the amplitude level of a differential signal varies with the fluctuation in power supply voltage. As a result, the amplitude level of the differential signal may fall below a range specified by the standard, resulting in the occurrence of a communication error.

A technology discussed herein has been made in view of the above, and is intended to achieve a wireless device capable of suppressing the occurrence of a communication error caused by a fluctuation in power supply voltage.

### [Solution to Problem]

A wireless device discussed in the present application, in one aspect, includes a wireless unit that performs signal processing on a radio signal and a baseband processing unit that is connected to the wireless unit through a digital communication channel and transmits/receives a digital signal with the wireless unit through the digital communication channel. The wireless device includes an event-initiation detecting unit that detects whether an event causing a fluctuation in power supply voltage supplied to the wireless unit or the baseband processing unit is initiated. The wireless device includes an amplitude-level control unit that increases, when the event-initiation detecting unit has detected that the event is initiated, amplitude of a digital signal transmitted/received through the digital communication channel before the event is initiated.

### [Advantageous Effects of Invention]

According to one aspect of a wireless device discussed in the present application, it is possible to suppress the occurrence of a communication error caused by a fluctuation in power supply voltage.

### [Brief Description of Drawings]

FIG. 1 is a diagram illustrating an overall configuration of a cellular phone.
FIG. 2 is a diagram illustrating an example of respective communication formats for a Tx Path and an Rx Path.
FIG. 3 is a diagram illustrating a configuration of a baseband processing unit.
FIG. 4 is a flowchart illustrating processing by the cellular phone.
FIG. 5A is a diagram for explaining an effect of the processing by the cellular phone.
FIG. 5B is a diagram for explaining an effect of the processing by the cellular phone.

### [Embodiments for Carrying Out the Invention]

An embodiment of a wireless device discussed in the present application will be explained in detail below based on accompanying drawings. Incidentally, the technology discussed herein is not limited to the following embodiment. In the following embodiment, a cellular phone is taken as an example of the wireless device; however, the wireless device is not limited to this, and can include any device which can perform wireless communication.

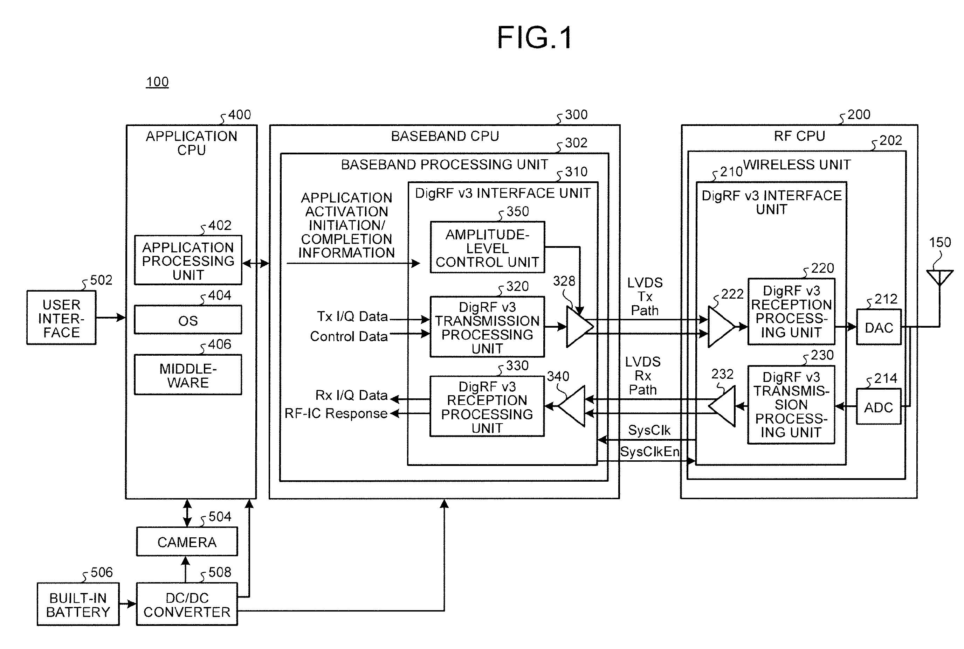

FIG. 1 is a diagram illustrating an overall configuration of a cellular phone. As illustrated in FIG. 1, a cellular phone 100 in the present embodiment includes an RF (Radio Frequency)-CPU (Central Processing Unit) 200 and a baseband CPU 300. Furthermore, the cellular phone 100 includes an application CPU 400, a user interface 502, a camera 504, a built-in battery 506, and a DC/DC converter 508.

The RF-CPU 200 includes a wireless unit 202. The wireless unit 202 includes a DigRF v3 interface unit 210, a DAC (Digital to Analog Converter) 212, and an ADC (Analog to Digital Converter) 214.

The ADC 214 receives a radio signal transmitted from an external wireless device via an antenna 150, and converts the received radio signal into a digital signal, and outputs the digital signal to the DigRF v3 interface unit 210. The DAC 212 converts a digital signal output from the DigRF v3 interface unit 210 into an analog radio signal, and transmits the analog radio signal to the outside via the antenna 150.

The DigRF v3 interface unit 210 includes a DigRF v3 reception processing unit 220, an LVDS Receiver 222, a DigRF v3 transmission processing unit 230, and an LVDS Driver 232. The LVDS Receiver 222 receives a transmission signal transmitted from the baseband CPU 300 through an LVDS Tx Path. The DigRF v3 reception processing unit 220 performs reception processing on the signal received by the LVDS Receiver 222, and outputs the processed signal to the DAC 212.

The DigRF v3 transmission processing unit 230 packetizes a digital signal received from the ADC 214 into a DigRF packet, and outputs the DigRF packet to the LVDS Receiver 222. The LVDS Driver 232 performs LVDS drive processing on the DigRF packet received from the DigRF v3 transmission processing unit 230, and outputs an LVDS signal to the baseband CPU 300 through an LVDS Rx Path.

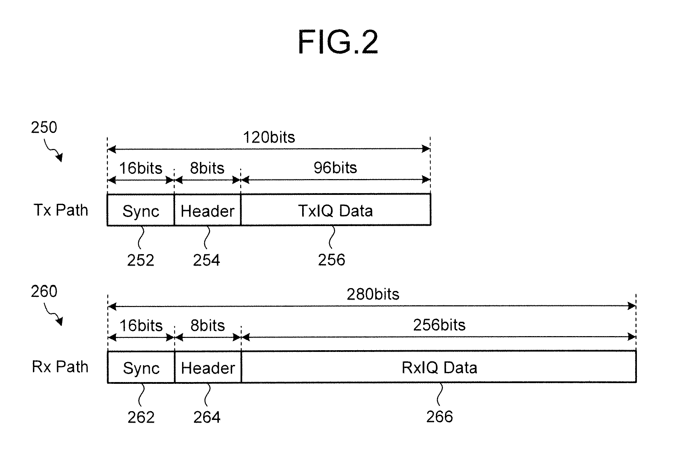

Here, respective communication formats of the LVDS signals transmitted through the LVDS Tx Path and the LVDS Rx Path are explained. FIG. 2 is a diagram illustrating an example of respective communication formats for a Tx Path and an Rx Path. As illustrated in FIG. 2, a communication format 250 for the Tx Path includes Sync 252 which is 16 synchronization detection pattern bits. Furthermore, the communication format 250 for the Tx Path includes 8-bit Header 254, which notifies of a type of data, and TxIQ Data 256, which is 96 Data bits called Payload.

A communication format 260 for the Rx Path includes Sync 262 which is 16 synchronization detection pattern bits. Furthermore, the communication format 260 for the Rx Path includes 8-bit Header 264, which notifies of a type of data, and RxIQ Data 266, which is 256 Data bits called Payload.

To return to the explanation of FIG. 1, the baseband CPU 300 includes a baseband processing unit 302. The baseband processing unit 302 includes a DigRF v3 interface unit 310. The DigRF v3 interface unit 310 includes a DigRF v3 transmission processing unit 320, an LVDS Driver 328, a DigRF v3 reception processing unit 330, an LVDS Rceiver 340, and an amplitude-level control unit 350.

The LVDS Rceiver 340 receives an LVDS signal output from the LVDS Driver 232. The DigRF v3 reception processing unit 330 performs reception processing on the LVDS signal received by the LVDS Rceiver 340, and outputs an Rx I/Q Data signal and an RF-IC Response signal.

### Details of the DigRF v3 reception processing unit 330 will be described later.

The DigRF v3 transmission processing unit 320 performs a process of generating a transmission signal to be transmitted to an external wireless device based on a Tx I/Q Data signal and a Control Data signal. The LVDS Driver 328 performs LVDS drive processing on the transmission signal generated by the DigRF v3 transmission processing unit 320, and outputs an LVDS signal to the RF-CPU 200 through the LVDS Tx Path. Details of the DigRF v3 transmission processing unit 320 will be described later.

When it has been detected that an event causing a fluctuation in power supply voltage supplied to the baseband processing unit 302 is initiated, the amplitude-level control unit 350 increases the amplitude of an LVDS signal transmitted/received through the Tx Path and the Rx Path before the event is initiated. The event here is activation of an application such as a TV phone installed in the cellular phone 100. Therefore, when there is a fluctuation in power supply with activation of an application such as a TV phone, the amplitude-level control unit 350 performs communication by increasing the amplitude level of an LVDS signal in advance before the activation of the application. For example, the amplitude-level control unit 350 increases a voltage supplied to the LVDS Driver 328, thereby increasing the amplitude of an LVDS signal output from the LVDS Driver 328. Incidentally, the event is not limited to activation of an application, and includes, for example, the lighting-up of a display unit of the cellular phone 100, activation of a vibrator of the cellular phone 100 on receipt, and activation of an alarm by a stationary function of the cellular phone 100, etc.

The application CPU 400 includes an application processing unit 402, an OS (Operating System) 404, and middleware 406. The application processing unit 402 performs processing for the execution of various applications software, such as a TV phone and image shooting, installed in the cellular phone 100. For example, at the execution of a TV phone application, the application processing unit 402 performs an activation process of the application including activation of the camera 504. The OS 404 performs processing such as process management and memory management for the cellular phone 100.

The middleware 406 transmits, for example, when having received an application activation request from the OS 404, the received application activation request to the application processing unit 402. The middleware 406 receives a request for activation of, for example, the TV phone application from the OS 404 as an event causing a fluctuation in power supply voltage supplied to the wireless unit 202 or the baseband processing unit 302. This enables the middleware 406 to detect whether an event causing a fluctuation in power supply voltage supplied to the wireless unit 202 or the baseband processing unit 302 is initiated. Furthermore, when the application processing unit 402 has completed an activation process of the TV phone application, the middleware 406 receives notification of the completion of the activation process of the TV phone application from the application processing unit 402. This enables the middleware 406 to detect whether the activation process of the TV phone application as an event causing a fluctuation in power supply voltage supplied to the wireless unit 202 or the baseband processing unit 302 has been completed.

The user interface 502 is an input interface such as various operation keys or a touch panel display of the cellular phone 100. The user interface 502 accepts a user input operation, and outputs the accepted input operation to the application CPU 400.

The camera 504 is a module that is activated in response to an activation request from the application processing unit 402 and takes an image. The camera 504 is activated, for example, at the time of activation of the TV phone application, and transmits a taken image to the application processing unit 402. The built-in battery 506 is a battery built into the cellular phone 100. The DC/DC converter 508 converts a voltage supplied from the built-in battery 506 into a different voltage, and supplies the converted voltage to the baseband CPU 300 and the application CPU 400, etc. Incidentally, in the present embodiment, there is provided an example where power supply voltage is supplied to the baseband CPU 300 and the application CPU 400; however, power supply voltage can be supplied from the DC/DC converter 508 to the RF-CPU 200.

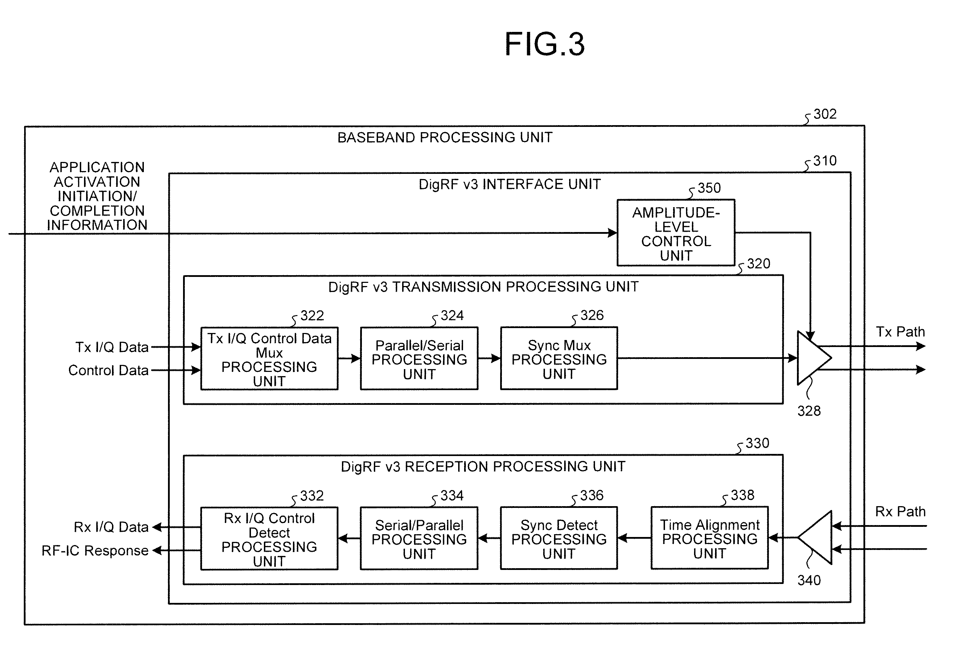

Subsequently, details of the baseband processing unit are explained. FIG. 3 is a diagram illustrating a configuration of the baseband processing unit. As illustrated in FIG. 3, the DigRF v3 transmission processing unit 320 includes a Tx I/Q Control Data Mux processing unit 322, a Parallel/Serial processing unit 324, and a Sync Mux processing unit 326. Furthermore, the DigRF v3 reception processing unit 330 includes an Rx I/Q Control Detect processing unit 332, a Serial/Parallel processing unit 334, a Sync Detect processing unit 336, and a Time Alignment processing unit 338.

The Tx I/Q Control Data Mux processing unit 322 performs multiplexing of Tx I/Q Data and Control Data. The Parallel/Serial processing unit 324 performs Serial conversion of the multiplexed data. The Sync Mux processing unit 326 performs a process of adding Sync bits to the Serial-converted data. The LCDS Driver 328 performs a process of converting data to be transmitted by LVDS into an LVDS signal, and transmits the LVDS signal to the RF-CPU 200 through the Tx Path.

The LVDS Receiver 340 receives data received by LVDS, and converts the data into a Single signal. The Time Alignment processing unit 338 performs a sampling process on a received signal received by the LVDS Receiver 340. The Sync Detect processing unit 336 detects Sync bits of the data subjected to the sampling process, and performs synchronization detection processing by comparison of whether or not it coincides with a Sync pattern specified by the DigRF v3 standard.

The Serial/Parallel processing unit 334 performs Parallel conversion of the data subjected to the synchronization detection processing. The Rx I/Q Control Detect processing unit 332 analyzes Header of the Parallel-converted data, and performs a process of separating Payload into Rx I/Q Data and RF-IC Response.

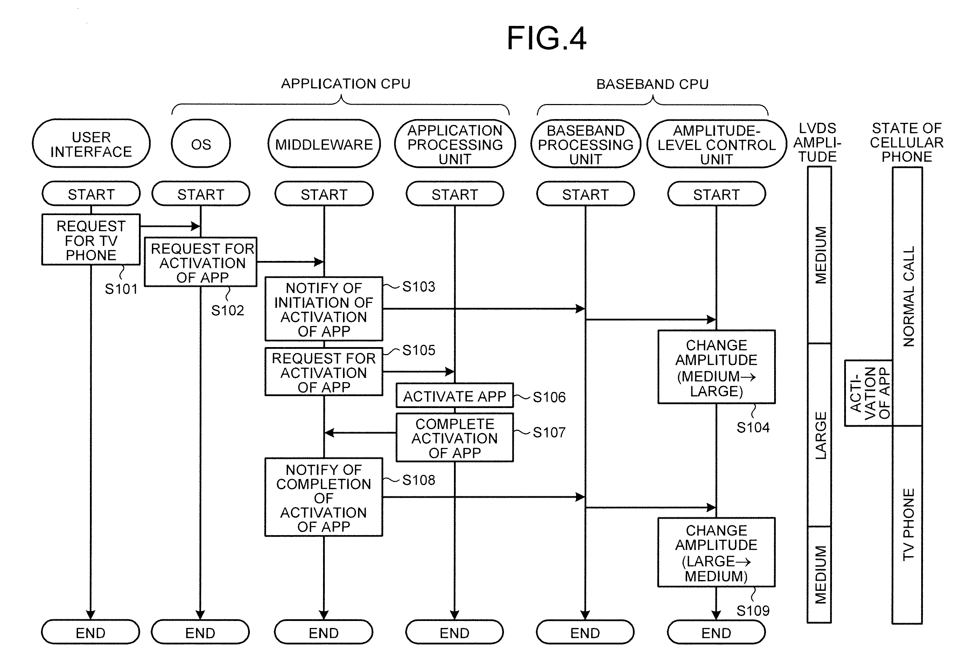

Subsequently, processing by the cellular phone 100 is explained. FIG. 4 is a flowchart illustrating the processing by the cellular phone 100. FIG. 4 illustrates a case where, as an example of an event causing a fluctuation in power supply voltage supplied to the baseband processing unit 302, the TV phone application is activated by a user input operation while the user is making a normal voice call.

As illustrated in FIG. 4, first, when the user interface 502 has received an operation to activate a TV phone by an user input operation, the user interface 502 issues a request for activation of the TV phone to the OS 404 (Step S101). Then, when having received the request for activation of the TV phone from the user interface 502, the OS 404 issues a request for activation of the TV phone application to the middleware 406 (Step S102).

Then, when having received the request for activation of the TV phone application, the middleware 406 notifies the baseband processing unit 302 that the TV phone application is activated (Step S103). A signal indicating that the TV phone application is activated is transmitted to the amplitude-level control unit 350 via the baseband processing unit 302. When the amplitude-level control unit 350 has received the signal indicating that the TV phone application is activated, the amplitude-level control unit 350 increases the amplitude of an LVDS signal output from the LVDS Driver 328 from medium to large (Step S104). This changes the amplitude of the LVDS signal from medium to large.

Then, the middleware 406 issues a request for activation of the TV phone application to the application processing unit 402 (Step S105). When having received the request for activation of the application from the middleware 406, the application processing unit 402 activates the TV phone application including activation of the camera 504 (Step S106). Then, the application processing unit 402 completes the activation process of the TV phone application (Step S107). When the activation process of the TV phone application has been completed, the cellular phone 100 is switched from normal voice call mode to TV phone mode.

When the application processing unit 402 has completed the activation process of the TV phone application, the middleware 406 notifies the baseband processing unit 302 that the activation process of the TV phone application has been completed (Step S108). A signal indicating that the activation process of the TV phone application has been completed is transmitted to the amplitude-level control unit 350 via the baseband processing unit 302. When the amplitude-level control unit 350 has received the signal indicating that the activation process of the TV phone application has been completed, the amplitude-level control unit 350 decreases the amplitude of an LVDS signal output from the LVDS Driver 328 from large to medium (Step S109). This changes the amplitude of the LVDS signal from large to medium.

Incidentally, when the cellular phone 100 is in sleep mode, the amplitude-level control unit 350 sets the amplitude level of an LVDS signal to small. For example, when the cellular phone 100 enters sleep mode in a state where the amplitude of an LVDS signal is medium, the amplitude-level control unit 350 changes the amplitude of an LVDS signal from medium to small. Furthermore, when the cellular phone 100 has been switched from sleep mode, for example, to normal voice call mode, the amplitude-level control unit 350 changes the amplitude of an LVDS signal from small to medium. Namely, in the cellular phone 100 according to the present embodiment, the amplitude level of an LVDS signal is set in three stages: "small" in sleep mode, "medium" in normal mode, and "large" at the initiation of an event causing a fluctuation in power supply voltage supplied to the baseband processing unit 302.

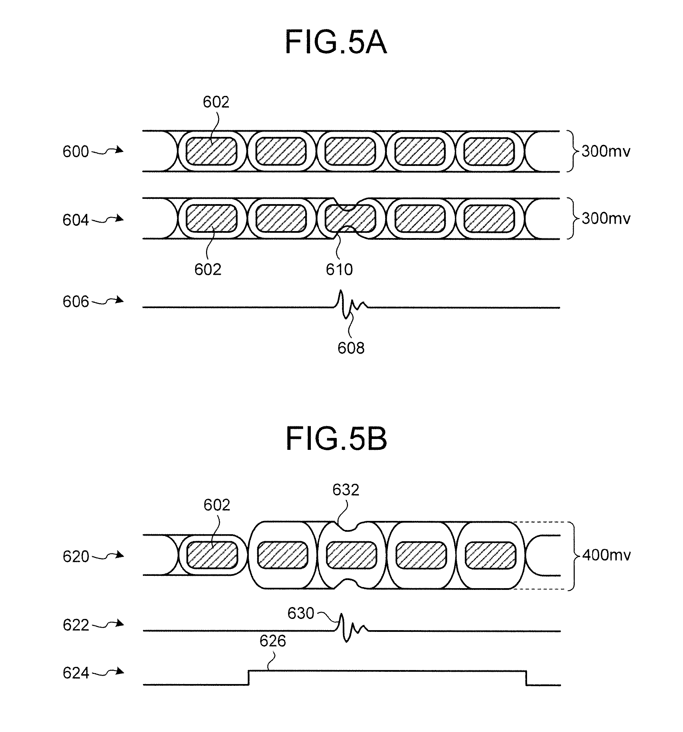

Subsequently, effects of the processing by the cellular phone 100 are explained. FIGS. 5A and 5B are diagrams for explaining the effects of the processing by the cellular phone. FIG. 5A illustrates an LVDS eye pattern 600 in a normal state, an LVDS eye pattern 604 when there is a fluctuation in power supply voltage supplied to the LVDS Driver 328, and a power supply voltage 606 of the LVDS Driver 328. FIG. 5B illustrates an LVDS eye pattern 620 when there is a fluctuation in power supply voltage supplied to the LVDS Driver 328, a power supply voltage 622 of the LVDS Driver 328, and app initiation/completion information 624 indicating an activation state of an app.

First, as illustrated in the LVDS eye pattern 600 in FIG. 5A, in the normal state, an LVDS signal is driven, for example, at an amplitude of 300 mv. In this case, the amplitude of the LVDS signal is larger than a threshold range 602 which enables normal communication, so communication is performed normally.

Meanwhile, when current consumption in the camera 504 is started by activation of an application such as a TV phone, an inrush current at the time may cause the occurrence of a fluctuation in power supply in the DC/DC converter 508, and, as a result, this may affect the current supply to the baseband processing unit 302. Accordingly, when there is a fluctuation 608 in the power supply voltage 606 of the LVDS Driver 328, in a portion of the LVDS eye pattern 604 corresponding to the fluctuation 608, the amplitude of an LVDS signal is smaller than the threshold range 602 which enables normal communication. As a result, for example, when there is an error in the Sync bits illustrated in FIG. 2, the Sync Detect processing unit 336 illustrated in FIG. 3 cannot detect a Sync pattern, and I/Q Data and Control Data may be discarded. Furthermore, a bit error may occur in Control Data. Consequently, wireless communication data cannot be normally transmitted/received, and therefore there may arise problems that it becomes difficult to control the RF-IC 200, and it brings throughput degradation.

On the other hand, as illustrated in FIG. 5B, in the LVDS eye pattern 620, the amplitude of an LVDS signal is increased, for example, to 400 mv in response to the detection of an initiation signal 626, which indicates that an application is activated, in the app initiation/completion information 624. Accordingly, even when there is a fluctuation 630 in the power supply voltage 622 of the LVDS Driver 328, although there is a fluctuation 632 in the LVDS eye pattern 620, the amplitude of an LVDS signal is larger than the threshold range 602 which enables normal communication. As a result, even when there is a fluctuation in power supply voltage of the LVDS Driver 328 (the baseband processing unit 302) due to activation of an application, communication can be performed normally.

Furthermore, as illustrated in FIG. 5B, in the LVDS eye pattern 620, the amplitude of an LVDS signal is put, for example, back to 300 mv, which is the before-increased amplitude, in response to the detection of completion of an activation process of the application in the app initiation/completion information 624. Accordingly, power consumption of the cellular phone 100 can be reduced.

As described above, according to the cellular phone 100 in the present embodiment, it is possible to suppress the occurrence of a communication error caused by a fluctuation in power supply voltage. Namely, when the amplitude-level control unit 350 has received information indicating that an application is activated from the middleware 406 included in the application CPU 400, the amplitude-level control unit 350 performs control of increasing the amplitude level of an LVDS signal output from the LVDS Driver 328. Accordingly, even when there is a fluctuation in power supply voltage of the baseband processing unit 302 due to activation of an application, the amplitude level of an LVDS signal can be controlled so as to be smaller than a threshold range specified by the standard. Consequently, it is possible to suppress the occurrence of a bit error of an LVDS signal, and therefore it is possible to suppress the occurrence of a communication error.

Incidentally, in the above-described embodiment, there is explained, as an example, the case where an event causing a fluctuation in power supply voltage supplied to the baseband processing unit 302 is initiated; however, the present embodiment is not limited to this. For example, the above-described embodiment can be also applied to a case where an event causing a fluctuation in power supply voltage supplied to the wireless unit 202 is initiated. Namely, when it has been detected that an event causing a fluctuation in power supply voltage supplied to the wireless unit 202 is initiated, the amplitude of an LVDS signal transmitted/received through a digital communication channel can be increased before the event is initiated. In this case, for example, an amplitude-level control unit is provided in the DigRF v3 interface unit 210 of the wireless unit 202, and this amplitude-level control unit increases voltage supplied to the LVDS Driver 232. Accordingly, the amplitude-level control unit increases the amplitude of an LVDS signal output from the LVDS Driver 232.

Furthermore, in the above-described embodiment, there is explained, as an example, the case where the amplitude of an LVDS signal is increased in DigRF standard-based digital communication between the RF-CPU 200 and the baseband CPU 300; however, the present embodiment is not limited to this. For example, also in other digital communication such as I2C communication, when it has been detected that an event causing a fluctuation in power supply voltage supplied to the wireless unit 202 or the baseband processing unit 302 is initiated, the amplitude-level control unit can increase the amplitude of a digital signal transmitted/received through a digital communication channel before the event is initiated.

Incidentally, in the above-described embodiment, the cellular phone 100 is mainly explained; however, the present embodiment is not limited to this, and the same functions as the above-described embodiment can be realized by causing a computer to execute an amplitude-level control program prepared in advance. Namely, the amplitude-level control program causes a wireless device, which includes a wireless unit that performs signal processing on a radio signal and a baseband processing unit that is connected to the wireless unit through a digital communication channel and transmits/receives a digital signal with the wireless unit through the digital communication channel, to execute the following processes. The amplitude-level control program causes the wireless device to execute a process of detecting whether an event causing a fluctuation in power supply voltage supplied to the wireless unit or the baseband processing unit is initiated. Furthermore, the amplitude-level control program causes the wireless device to execute a process of increasing, when having detected that the event is initiated, the amplitude of a digital signal transmitted/received through the digital communication channel before the event is initiated. Incidentally, the amplitude-level control program can be distributed to a computer via a communication network such as the Internet. Furthermore, the amplitude-level control program can be recorded on a computer-readable recording medium such as a memory installed in the wireless device, a hard disk, or the like, so that a computer can read out the amplitude-level control program from the recording medium and execute the amplitude-level control program.

### [Explanation of Reference]

- 100: Cellular phone
- 202: Wireless unit
- 232: LVDS Driver
- 302: Baseband processing unit
- 328: LVDS Driver
- 350: Amplitude-level control unit
- 402: Application processing unit
- 406: Middleware

## Claims

1. A wireless device comprising:
a wireless unit that performs signal processing on a radio signal;
a baseband processing unit that is connected to the wireless unit through a digital communication channel, and transmits/receives a digital signal with the wireless unit through the digital communication channel;
an event-initiation detecting unit that detects whether an event causing a fluctuation in power supply voltage supplied to the wireless unit or the baseband processing unit is initiated; and
an amplitude-level control unit that increases, when the event-initiation detecting unit has detected that the event is initiated, amplitude of a digital signal transmitted/received through the digital communication channel before the event is initiated.

2. The wireless device according to claim 1, wherein
the amplitude-level control unit increases voltage supplied to a first driver that is installed in the wireless unit and transmits the digital signal to the baseband processing unit, or increases voltage supplied to a second driver that is installed in the baseband processing unit and transmits the digital signal to the wireless unit.

3. The wireless device according to claim 1, further including an event-initiation completion detecting unit that detects whether an initiation process of the event has been completed, wherein
when the event-initiation completion detecting unit has detected that the initiation process of the event has been completed, the amplitude-level control unit puts the amplitude of the digital signal transmitted/received through the digital communication channel to before-increased amplitude.

4. The wireless device according to claim 1, wherein
the event is at least any one of activation of an application of the wireless device, lighting-up of a display unit of the wireless device, activation of a vibrator of the wireless device on receipt, and activation of an alarm of the wireless device.
